(19) **Europäisches Patentamt**
**European Patent Office**
**Office européen des brevets**

(11) **EP 3 605 917 A1**

(12) **EUROPEAN PATENT APPLICATION**
published in accordance with Art. 153(4) EPC

(43) Date of publication:
**05.02.2020 Bulletin 2020/06**

(51) Int Cl.:
**H04L 1/22** $^{(2006.01)}$

(21) Application number: **18787799.8**

(22) Date of filing: **09.04.2018**

(86) International application number:
**PCT/CN2018/082399**

(87) International publication number:
**WO 2018/192387 (25.10.2018 Gazette 2018/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.04.2017 CN 201710262997**

(71) Applicant: **Huawei Technologies Co., Ltd.**
**Longgang District**
**Shenzhen, Guangdong 518129 (CN)**

(72) Inventors:
• **MA, Liang**
**Shenzhen**
**Guangdong 518129 (CN)**

• **ZENG, Xin**
**Shenzhen**
**Guangdong 518129 (CN)**
• **WEI, Yuejun**
**Shenzhen**
**Guangdong 518129 (CN)**
• **ZHANG, Chaolong**
**Shenzhen**
**Guangdong 518129 (CN)**
• **ZHANG, Gongzheng**
**Shenzhen**
**Guangdong 518129 (CN)**

(74) Representative: **Epping - Hermann - Fischer**
**Patentanwaltsgesellschaft mbH**
**Schloßschmidstraße 5**
**80639 München (DE)**

(54) **INFORMATION PROCESSING METHOD AND APPARATUS, AND COMMUNICATION DEVICE**

(57) This application discloses an information processing method and apparatus, a communications device, and a communications system. The method may be used in a communications system in which channel encoding is performed through LDPC encoding, and includes: adding redundancy check bits to a bit sequence A corresponding to first information to obtain a bit sequence C; performing cyclic shift on the bit sequence C based on a shift t and a lifting factor z to obtain a bit sequence $C^t$, where t is an integer greater than or equal to 0, and the shift t is obtained based on second information; and performing low-density parity-check LDPC encoding on the bit sequence $C^t$ to obtain a bit sequence $D^t$. In this method, an LDPC code word sequence obtained after processing can reduce a system bandwidth and a resource that are occupied, to meet a performance requirement of a system.

FIG. 3

**Description**

**TECHNICAL FIELD**

Embodiments of the present invention relate to the communications field, and in particular, to an information processing method and apparatus and a communications device.

**BACKGROUND**

An LDPC code is a type of linear block code having a sparse check matrix, and is characterized by a flexible structure and low decoding complexity. In a fifth-generation mobile communications system, a low-density parity-check (low density parity check, LDPC) code has been considered as one of channel coding manners.

In a communications system, some information needs to be transmitted between a communications device at a receive end and a communications device at a transmit end, for example, information used to indicate a quantity of ports of an antenna and a transmitting time. The information is usually added to control information or data information on a corresponding channel. If the channel uses LDPC encoding, additional redundancy bits are attached to the added information, resulting in an increase in a code rate after encoding. If the information is transmitted to the communications device at a receive end in the communications system, a bandwidth and a resource of the system are occupied, decoding performance of the communications device at the receive end is degraded, and system overheads are increased.

**SUMMARY**

Embodiments of the present invention provide an information processing method and apparatus, a communications device, and a communications system, to reduce a system bandwidth and a resource that are occupied, thereby meeting a performance requirement of a system.

According to a first aspect, an information processing method is provided, including:

adding redundancy check bits to a bit sequence A corresponding to first information to obtain a bit sequence C;

performing cyclic shift on the bit sequence C based on a shift t and a lifting factor z to obtain a bit sequence $C^t$, where t is an integer greater than or equal to 0, and the shift t is obtained based on second information; and

performing low-density parity-check LDPC encoding on the bit sequence $C^t$ to obtain a bit sequence $D^t$.

In this method, an LDPC codeword sequence obtained after processing can reduce a system bandwidth and a resource that are occupied, to meet a performance requirement of a system. With reference to the first aspect, in a first possible implementation of the first aspect, the adding a redundancy check to a bit sequence A corresponding to first information to obtain a bit sequence C includes:

scrambling the bit sequence A corresponding to the first information, and adding the redundancy check bits to a scrambled bit sequence to obtain the bit sequence C.

With reference to the first aspect, in a second possible implementation of the first aspect, the adding a redundancy check to a bit sequence A corresponding to first information to obtain a bit sequence C includes:

adding the redundancy check bits to the bit sequence A corresponding to the first information; and scrambling a bit sequence obtained by adding the redundancy check bits to obtain the bit sequence C.

With reference to the first aspect or any possible implementation of the first aspect, in a third possible implementation of the first aspect, the method further includes: performing cyclic shift on the bit sequence C based on a shift (t+d) to obtain a bit sequence $C^{t+d}$, where d is an integer greater than 0, and is obtained based on third information; and performing low-density parity-check LDPC encoding on the bit sequence $C^{t+d}$ to obtain a bit sequence $D^{t+d}$.

The bit sequence $D^{t+d}$ may be used by a communications device at a receive end to perform soft value combination decoding, so as to provide a decoding success rate.

According to a second aspect, an information processing apparatus is provided, including:

a check unit, configured to add redundancy check bits to a bit sequence A corresponding to first information to obtain a bit sequence C;

a processing unit, configured to perform cyclic shift on the bit sequence C based on a shift t and a lifting factor z to obtain a bit sequence $C^t$, where t is an integer greater than or equal to 0, and the shift t is obtained based on second information; and

an encoding unit, configured to perform low-density parity-check LDPC encoding on the bit sequence $C^t$ to obtain a bit sequence $D^t$.

The apparatus may be configured to perform the method according to the first aspect or any possible implementation of the first aspect. For details, refer to descriptions of the foregoing aspects.

In a possible design, the information processing apparatus provided in this application may include a module corresponding to the first aspect or any possible implementation of the first aspect in the foregoing method design. The module may be software and/or hardware.

In the foregoing aspects, information that needs to be transmitted by a communications device is carried in an encoded LDPC code word through cyclic shift, thereby reducing system overheads. In the first aspect, the second aspect, any possible implementation of the first aspect, or any possible implementation of the second aspect, the performing cyclic shift on the bit sequence C based on a shift t and a lifting factor z to obtain a bit sequence $C^t$ includes: separately performing t-bit cyclic shift on every z bits in the bit sequence C to obtain the bit sequence $C^t$.

The performing t-bit cyclic shift on every z bits in the bit sequence C to obtain the bit sequence $C^t$ includes: performing t-bit cyclic shift on all bits in every z bits in the bit sequence C to obtain the bit sequence $C^t$; or performing t-bit cyclic shift on (z-f) bits in every z bits in the bit sequence C to obtain the bit sequence $C^t$, where t is less than or equal to (z-f).

In the foregoing aspects or any possible implementation of the aspects, the bit sequence C includes $n_b$ bit segments, namely, $C_0$, $C_1$, $C_2$, $C_3$, ..., $C_{n_b-1}$, each bit segment $C_i$ includes z bits, the bit sequence $C^t$ includes $n_b$ bit segments, namely, $C_0^t, C_1^t, C_2^t, C_3^t, ..., C_{n_b-1}^t$, and each bit segment $C_i^t$ includes z bits, where the bit segment $C_i^t$ is obtained by performing t-bit cyclic shift on the bit segment $C_i$.

According to a third aspect, an information processing method is provided, including:

adding redundancy check bits to a bit sequence A corresponding to first information to obtain a bit sequence C;
performing low-density parity-check LDPC encoding on the bit sequence C to obtain a bit sequence D; and
performing cyclic shift on the bit sequence D based on a shift t and a lifting factor z to obtain a bit sequence $D^t$, where t is an integer greater than or equal to 0, and the shift t is obtained based on second information.

In this method, an LDPC codeword sequence obtained after processing can reduce a system bandwidth and a resource that are occupied, to meet a performance requirement of a system. With reference to the third aspect, in a first possible implementation of the third aspect, the adding a redundancy check to a bit sequence A corresponding to first information to obtain a bit sequence C includes: scrambling the bit sequence A corresponding to the first information, and adding the redundancy check bits to a scrambled bit sequence to obtain the bit sequence C.

With reference to the third aspect, in a second possible implementation of the third aspect, the adding a redundancy check to a bit sequence A corresponding to first information to obtain a bit sequence C includes: adding the redundancy check bits to the bit sequence A corresponding to the first information; and scrambling a bit sequence obtained by adding the redundancy check bits to obtain the bit sequence C.

With reference to the third aspect or any possible implementation of the third aspect, in a third possible implementation of the third aspect, the method further includes: performing cyclic shift on the bit sequence D based on a shift (t+d) to obtain a bit sequence $D^{t+d}$, where d is an integer greater than 0, and is obtained based on third information.

The bit sequence $D^{t+d}$ may be used by a communications device at a receive end to perform soft value combination decoding, so as to provide a decoding success rate.

According to a fourth aspect, an information processing apparatus is provided, including:

a check unit, configured to add redundancy check bits to a bit sequence A corresponding to first information to obtain a bit sequence C;
an encoding unit, configured to perform low-density parity-check LDPC encoding on the bit sequence C to obtain a bit sequence D; and
a processing unit, configured to perform cyclic shift on the bit sequence D based on a shift t and a lifting factor z to obtain a bit sequence $D^t$, where t is an integer greater than or equal to 0, and the shift t is obtained based on second information.

The apparatus may be configured to perform the method according to the third aspect or any possible implementation of the third aspect. For details, refer to descriptions of the foregoing aspects.

In a possible design, the information processing apparatus provided in this application may include a module corresponding to the second aspect or any possible implementation of the second aspect in the foregoing method design. The module may be software and/or hardware.

In the foregoing aspects, information that needs to be transmitted by a communications device is carried in an encoded LDPC code word through cyclic shift, thereby reducing system overheads. In the third aspect, the fourth aspect, any possible implementation of the third aspect, or any possible implementation of the fourth aspect, the performing cyclic shift on the bit sequence D based on a shift t and a lifting factor z to obtain a bit sequence $D^t$ includes: separately performing t-bit cyclic shift on every z bits in the bit sequence D to obtain the bit sequence $D^t$.

The performing t-bit cyclic shift on every z bits in the bit sequence D to obtain the bit sequence $D^t$ includes: performing t-bit cyclic shift on all bits in every z bits in the bit sequence D to obtain the bit sequence $D^t$; or performing t-bit cyclic shift on (z-f) bits in every z bits in the bit sequence D to obtain the bit sequence $D^t$, where t is less than or equal to (z-f).

In the foregoing aspects or any possible implementation of the aspects, the bit sequence D includes $n_b$ bit segments, namely, $D_0$, $D_1$, $D_2$, $D_3$, ..., $D_{n_b -1}$, each bit segment $D_i$ includes z bits, the bit sequence $D^t$ includes $n_b$ bit segments, namely, $D_0^t, D_1^t, D_2^t, D_3^t, ..., D_{n_b-1}^t$, and each bit segment $D_i^t$ includes z bits, where the bit segment $D_i^t$ is obtained by performing t-bit cyclic shift on the bit segment $D_i$.

According to a fifth aspect, an information processing method is provided, including:

performing reverse cyclic shift on a first soft value sequence based on a shift t and a lifting factor z to obtain a soft value sequence corresponding to a bit sequence D, where t is an integer greater than or equal to 0;
performing low-density parity-check LDPC decoding on the soft value sequence corresponding to the bit sequence D to obtain a bit sequence C; and
if redundancy check is performed on the bit sequence C and a check result is correct, obtaining second information based on the shift t.

In this method, an LDPC code word sequence obtained after processing can reduce a system bandwidth and a resource that are occupied, to meet a performance requirement of a system. With reference to the fifth aspect, in a first possible implementation of the fifth aspect, the performing redundancy check on the bit sequence C includes:

descrambling the bit sequence C, and performing redundancy check on a descrambled bit sequence; or
performing redundancy check on the bit sequence C, and if a redundancy check result is correct, descrambling a bit sequence with a correct check result to obtain a bit sequence A corresponding to first information.

According to a sixth aspect, an information processing apparatus is provided, including:

a processing unit, configured to perform reverse cyclic shift on a first soft value sequence based on a shift t and a lifting factor z to obtain a soft value sequence corresponding to a bit sequence D, where t is an integer greater than or equal to 0;
a decoding unit, configured to perform low-density parity-check LDPC decoding on the soft value sequence corresponding to the bit sequence D to obtain a bit sequence C; and
a check unit, configured to perform redundancy check on the bit sequence C, where
the processing unit is further configured to obtain second information based on the shift t if a check result of the check unit is correct.

The apparatus may be configured to perform the method according to the fifth aspect or any possible implementation of the fifth aspect. For details, refer to descriptions of the foregoing aspects.

In a possible design, the information processing apparatus provided in this application may include a module corresponding to the fifth aspect or any possible implementation of the fifth aspect in the foregoing method design. The module may be software and/or hardware.

In the foregoing aspects, a communications device obtains, through reverse cyclic shift, information carried in an LDPC code word, thereby reducing system overheads.

In the fifth aspect, the sixth aspect, any possible implementation of the fifth aspect, or any possible implementation of the sixth aspect, the performing reverse cyclic shift on the first soft value sequence based on a shift t and a lifting factor z to obtain a soft value sequence corresponding to a bit sequence D includes: separately performing t-bit reverse cyclic shift on every z bits in the first soft value sequence to obtain a soft value sequence corresponding to the bit sequence D.

The performing t-bit reverse cyclic shift on every z bits in the first soft value sequence to obtain a soft value sequence corresponding to the bit sequence D includes: performing t-bit reverse cyclic shift on all bits in every z bits in the first soft value sequence to obtain the soft value sequence corresponding to the bit sequence D; or performing t-bit reverse cyclic shift on (z-f) bits in every z bits in the first soft value sequence to obtain the soft value sequence corresponding to the bit sequence D, where t is less than or equal to (z-f).

According to a seventh aspect, an information processing method is provided, including:

performing low-density parity-check LDPC decoding based on a first soft value sequence to obtain a bit sequence $C^t$;
performing reverse cyclic shift on the bit sequence $C^t$ based on a shift t and a lifting factor z to obtain a bit sequence C, where t is an integer greater than or equal to 0; and
if redundancy check is performed on the bit sequence C and a check result is correct, obtaining second information based on the shift t.

In this method, an LDPC code word sequence obtained after processing can reduce a system bandwidth and a resource that are occupied, to meet a performance requirement of a system. With reference to the seventh aspect, in a first possible implementation of the seventh aspect, the performing redundancy check on the bit sequence C includes:

descrambling the bit sequence C, and performing redundancy check on a descrambled bit sequence; or
performing redundancy check on the bit sequence C, and if a redundancy check result is correct, descrambling a bit sequence with a correct check result to obtain a bit sequence A corresponding to first information.

According to an eighth aspect, an information processing apparatus is provided, including:

a decoding unit, configured to perform low-density parity-check LDPC decoding based on a first soft value sequence to obtain a bit sequence $C^t$;
a processing unit, configured to perform reverse cyclic shift on the bit sequence $C^t$ based on a shift t and a lifting factor z to obtain a bit sequence C, where t is an integer greater than or equal to 0; and
a check unit, configured to perform redundancy check on the bit sequence C, where
the processing unit is further configured to obtain second information based on the shift t if a check result of the check unit is correct.

The apparatus may be configured to perform the method according to the seventh aspect or any possible implementation of the seventh aspect. For details, refer to descriptions of the foregoing aspects.

In a possible design, the information processing apparatus provided in this application may include a module corresponding to the seventh aspect or any possible implementation of the seventh aspect in the foregoing method design. The module may be software and/or hardware. In the foregoing aspects, a communications device obtains, through reverse cyclic shift, information carried in an LDPC code word, thereby reducing system overheads.

In the seventh aspect, the eighth aspect, any possible implementation of the seventh aspect, or any possible implementation of the eighth aspect, the performing reverse cyclic shift on the bit sequence $C^t$ based on a shift t and a lifting factor z to obtain a bit sequence C includes:
separately performing t-bit reverse cyclic shift on every z bits in the bit sequence $C^t$ to obtain the bit sequence C.

The performing t-bit reverse cyclic shift on every z bits in the bit sequence $C^t$ to obtain the bit sequence C includes: performing t-bit reverse cyclic shift on all bits in every z bits in the bit sequence $C^t$ to obtain the corresponding bit sequence C; or performing t-bit reverse cyclic shift on (z-f) bits in every z bits in the bit sequence $C^t$ to obtain the bit sequence C, where t is less than or equal to (z-f).

In the fifth aspect to the eighth aspect or any possible implementation of the fifth aspect to the eighth aspect, the first soft value sequence is a second soft value sequence corresponding to a bit sequence $D^t$, or a sequence obtained by combining a second soft value sequence corresponding to a bit sequence $D^t$ with a third soft value sequence corresponding to the bit sequence $D^t$, where the third soft value sequence corresponding to the bit sequence $D^t$ is obtained by performing reverse cyclic shift on a soft value sequence corresponding to a bit sequence $D^{t+d}$ based on a shift d and a lifting factor z.

A communications device at a receive end may obtain a gain of soft value combination decoding by using the foregoing implementations.

According to a ninth aspect, a communications device is provided, including a shift encoder and a transceiver.

The shift encoder includes the information processing apparatus according to the fifth aspect, and is configured to perform, based on second information, cyclic shift and LDPC encoding on first information with redundancy check bits to obtain an LDPC code word; alternatively, the shift encoder includes the information processing apparatus according to the sixth aspect, and is configured to perform, based on second information, cyclic shift on first information with redundancy check bits and LDPC encoding to obtain an LDPC code word.

The transceiver is configured to send a signal corresponding to the LDPC code word. According to a tenth aspect, a communications device is provided, including a shift decoder and a transceiver.

The transceiver is configured to receive a signal corresponding to an LDPC code word of first information.

The shift decoder includes the information processing apparatus according to the seventh aspect, and is configured to perform reverse cyclic shift, decoding, and redundancy check on an LDPC code word received by the transceiver, and determine second information based on a redundancy check result and a quantity of bits subjected to the reverse cyclic shift; alternatively, the shift decoder includes the information processing apparatus according to the eighth aspect, and is configured to perform decoding, reverse cyclic shift, and redundancy check on an LDPC code word received by the transceiver, and determine second information based on a redundancy check result and a quantity of bits subjected to the reverse cyclic shift.

The transceiver is configured to send a signal corresponding to the LDPC code word.

In any one of the foregoing aspects or a possible implementation of any aspect, the second information includes at least one of the following information: time domain information, frequency domain information, subcarrier information, redundancy version information, or antenna port information.

In any one of the foregoing aspects or a possible implementation of any aspect, the shift t has Q different values, and if the shift t and the lifting factor z meet z mod Q+nQ>0, f = (z mod Q+nQ), where Q is an integer greater than 0 and n is an integer greater than or equal to 0.

According to an eleventh aspect, an embodiment of the present invention provides a communications system, where the system includes the communications device according to the ninth aspect and the communications device according to the tenth aspect.

In another aspect, an embodiment of the present invention provides a computer storage medium, and the computer storage medium includes a program used to perform the foregoing aspects. Another aspect of this application provides a computer program product that includes an instruction, and when the computer program product runs on a computer, makes the computer to perform the methods in the foregoing aspects.

According to the information processing method and apparatus, the communications device, and the communications system in the embodiments of the present invention, cyclic shift is performed on a bit sequence based on information that needs to be transmitted, and an LDPC code word obtained after processing can reduce a system bandwidth and a resource that are occupied, to meet a performance requirement of a system.

**BRIEF DESCRIPTION OF DRAWINGS**

FIG. 1 is a schematic diagram of a communications system according to an embodiment of the present invention;
FIG. 2a is a schematic diagram of a base graph of an LDPC code according to another embodiment of the present invention;
FIG. 2b is a schematic diagram of a base matrix of an LDPC code according to another embodiment of the present invention;
FIG. 2c is a schematic diagram of a circular permutation matrix of an LDPC code according to another embodiment of the present invention;
FIG. 3 is a flowchart of an information processing method according to another embodiment of the present invention;
FIG. 4 is a flowchart of an information processing method according to another embodiment of the present invention;
FIG. 5 is a flowchart of an information processing method according to another embodiment of the present invention;
FIG. 6 is a flowchart of an information processing method according to another embodiment of the present invention;
FIG. 7 is a structural diagram of an information processing apparatus according to another embodiment of the present invention;
FIG. 8 is a structural diagram of an information processing apparatus according to another embodiment of the present invention;
FIG. 9 is a structural diagram of an information processing apparatus according to another embodiment of the present invention;
FIG. 10 is a structural diagram of an information processing apparatus according to another embodiment of the present invention;
FIG. 11 is a structural diagram of a communications device according to another embodiment of the present invention; and
FIG. 12 is a structural diagram of a communications device according to another embodiment of the present invention.

**DESCRIPTION OF EMBODIMENTS**

The following describes the technical solutions in the embodiments of the present invention with reference to the accompanying drawings in the embodiments of the present invention.

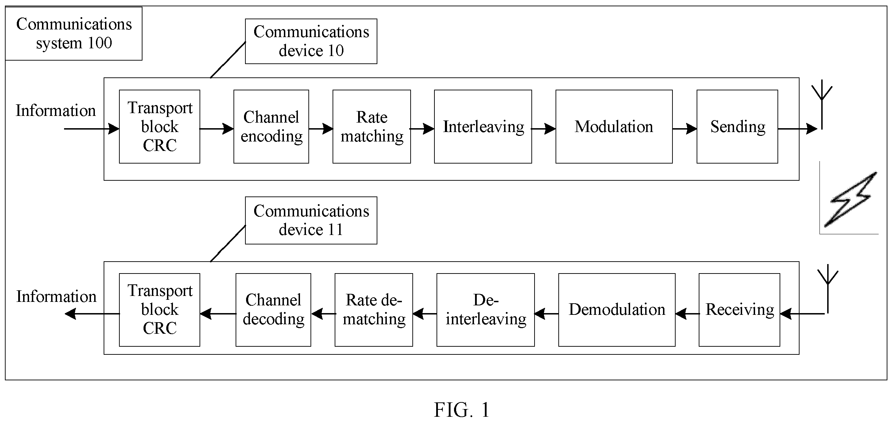

A communications system 100 shown in FIG. 1 may be widely used to provide various types of communication, such as voice communication and data communication. The communications system may include a plurality of wireless communications devices. For clarity, FIG. 1 only shows a communications device 10 and a communications device 11. Control information or data information is received and sent between the communications device 10 and the communications device 11 as an information bit sequence. The communications device 10 serves as a communications device at a transmit end, and sends control information or data information on different channels at locations of corresponding resources such as time domain and frequency domain after encoding. Because there is more interference in air interface transmission, to improve reliability, a cyclic redundancy check (cyclical redundancy check, CRC) bit is added to a bit sequence of the control information or the data information before encoding.

The communications device 11 serves as a communications device at a receive end, receives signals that include the control information or the data information from different channels, then decodes the signals, and performs CRC check on a bit sequence obtained through decoding. If the check succeeds, it indicates that a received information bit sequence is decoded correctly, in other words, correct control information or data information is received. The communications device 11 usually performs an inverse process of an information processing method of the communications device 10. It should be noted that, in the embodiments of the present invention, the communications device 10 may be a network device in the communications system, such as a base station, and correspondingly, the communications device 11 may be a terminal. Alternatively, the communications device 10 may be a terminal in the communications system, and correspondingly, the communications device 11 may be a network device in the communications system, such as a base station.

To facilitate understanding, the following describes some nouns used in this application.

In this application, nouns "network" and "system" are usually interchangeably used, but meanings of the nouns may be understood by a person skilled in the art. The terminal is a device having a communication function, and may include a handheld device, an in-vehicle device, a wearable device, or a computing device that has a wireless communication function, another processing device connected to a wireless modem, or the like. The terminal may have different names in different networks, for example, user equipment, a mobile station, a subscriber unit, a station, a cellular phone, a personal digital assistant, a wireless modem, a wireless communications device, a handheld device, a laptop computer, a cordless phone, and a wireless local loop station. For ease of description, these devices are simply referred to as a terminal in this application. A base station (base station, BS) may also be referred to as a base station device, and is a device deployed in a radio access network to provide a wireless communication function. The base station may have different names in different wireless access systems. For example, a base station in a universal mobile telecommunications system (Universal Mobile Telecommunications System, UMTS) network is referred to as a NodeB (NodeB), a base station in an LTE network is referred to as an evolved NodeB (evolved NodeB, eNB or eNodeB), a base station in a new radio (new radio, NR) network is referred to as a transmission reception point (transmission reception point, TRP) or a next generation NodeB (generation nodeB, gNB), or base stations in other evolved networks may have other names. The present invention is not limited thereto.

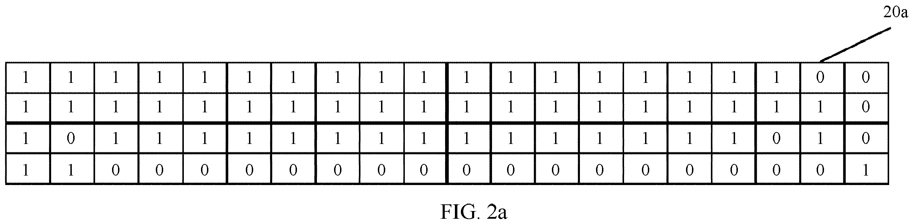

FIG. 2a to FIG. 2c are schematic diagrams of a base graph (base graph), a base matrix (base matrix), and a circular permutation matrix (circulant permutation matrix) of an LDPC code as an example.

An LDPC code may be usually represented by a parity-check matrix H. The parity-check matrix H of the LDPC code may be obtained by using a base graph and a shift (shift) value. The base graph may usually include m*n matrix elements, and may be represented by using a matrix with m rows and n columns, and a value of a matrix element is 0 or 1. An element whose value is 0 is sometimes referred to as a zero element, that is, the element may be replaced with an all-zero matrix (zero matrix) of size z*z. An element whose value is 1 is sometimes referred to as a non-zero element, that is, the element may be replaced with a circular permutation matrix of size z*z. z is a positive integer, may also be referred to as a lifting (lifting) factor, and may be determined based on a size of a code block supported by a system or a size of information data. FIG. 2a shows elements in an example base graph 20a of an LDPC code with a QC structure, where m=4, and n=20.

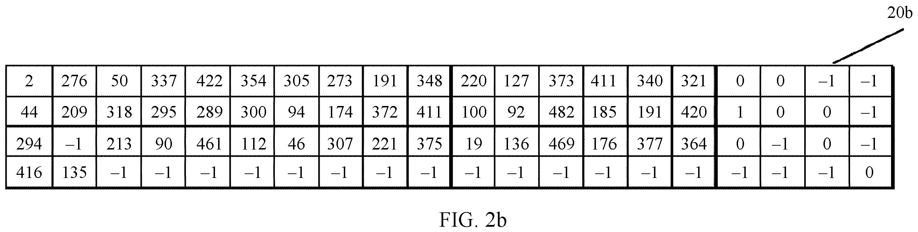

For ease of implementation, the system usually defines a base matrix of m*n. Elements in the base matrix are in a one-to-one correspondence with positions of the elements in the base graph. A zero element in the base graph has a fixed position in the base matrix, and is indicated by -1. A non-zero element, in row i and column j, whose value is 1 in the base graph has a fixed position in the base matrix, and is indicated by an offset $P_{i,j}$. $P_{i,j}$ is an integer greater than or equal to 0, indicating that an element, in row i and column j, whose value is 1 may be replaced with a circular permutation matrix of size z*z corresponding to $P_{i,j}$. The circular permutation matrix may be obtained by circularly shifting an identity matrix of size z*z to the right $P_{i,j}$ times. As shown in FIG. 2b, 20b is a base matrix corresponding to the base graph 20a.

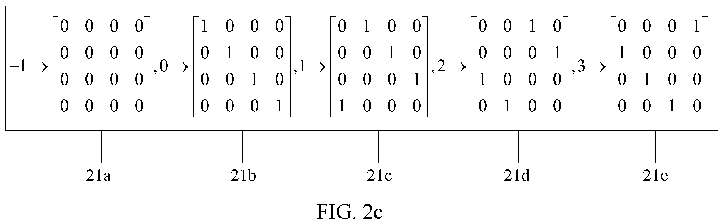

It can be learned that each element whose value is 0 in the base graph is replaced by an all-zero matrix of size z*z, and each element whose value is 1 is replaced by a circular permutation matrix of z*z corresponding to an offset of the element, to obtain the parity-check matrix of the LDPC code. The size of the parity-check matrix is (m*z)*(n*z). FIG. 2c shows an all-zero matrix 21a and circular permutation matrices 21b to 21e of 4*4 in size corresponding to different offsets when the lifting factor is 4. For example, if the lifting factor z=4, each zero element is replaced with an all-zero matrix 21a of size 4*4 in size. If $P_{2,3}$ =2, a non-zero element in row 2 and column 3 is replaced with a circular permutation matrix 21d of 4*4, and the matrix is obtained by circularly shifting an identity matrix 21b of size 4*4 to the right 2 times. If $P_{2,4}$ =0, the non-zero element in the second row and the third column is replaced with the identity matrix 21b. It should be noted that only examples are described herein, and the examples do not constitute a limitation.

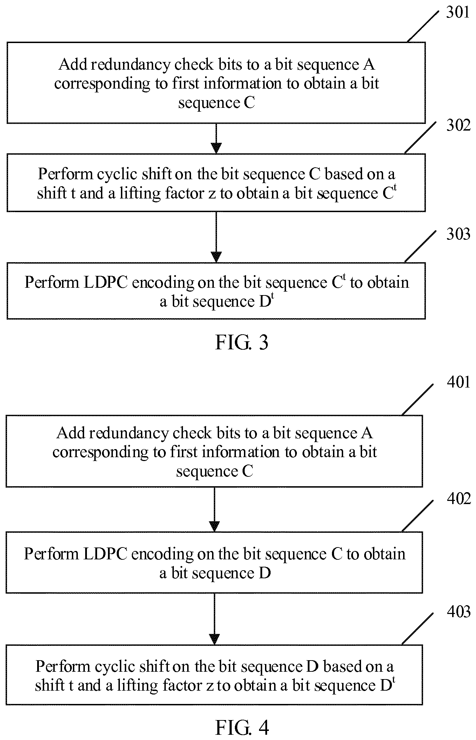

FIG. 3 is a flowchart of an information processing method according to an embodiment of the present invention, and the information processing method may be applied to a channel on which LDPC encoding is used, and includes:
301. Add redundancy check bits to a bit sequence A corresponding to first information to obtain a bit sequence C.

Control information or data information that needs to be transmitted on a channel may be usually represented as a bit sequence. Redundancy check bits need to be added before encoding is performed. A common redundancy check method includes cyclic redundancy check CRC, parity check, and the like. For ease of description, in this application, the control information or the data information that needs to be transmitted on the channel is referred to as the first information, and a bit sequence corresponding to the first information is referred to as the bit sequence A.

L redundancy check bits may be added to the bit sequence A, where L is an integer and is greater than 0, for example, L may be 24 or 16.

The bit sequence C may be represented as a sequence consisting of $[C_0, C_1, C_2, C_3,..., C_{n_b 1}]$, where each element $C_i$ represents a bit segment whose length is z, in other words, each bit segment $C_i$ includes z bits, and i is an integer greater than or equal to 0 and less than $n_b$. The redundancy check bits are usually at the last L bits of the bit sequence C.

Optionally, to avoid interference by an all-zero sequence to cyclic shift, in a possible implementation, scrambling may be performed first on the bit sequence A corresponding to the first information. For example, a segment of mask is used to scramble all or some of bits in the bit sequence A, for example, modulo-2 scrambling is performed on all or some of bits in the bit sequence A, and then the redundancy check bits are added to a scrambled bit sequence to obtain the bit sequence C.

In another possible implementation, the redundancy check may alternatively be performed first on the bit sequence A corresponding to the first information, and then scrambling is performed on all or some of bits in a bit sequence obtained by adding the redundancy check bits to obtain the bit sequence C.

For example, if the bit sequence A is an all-zero sequence, scrambling may be performed on all or some of bits in the bit sequence A, and then a redundancy check bits are added to a scrambled bit sequence to obtain the bit sequence C.

302. Perform cyclic shift on the bit sequence C based on a shift t and a lifting factor z to obtain a bit sequence $C^t$, where t is an integer greater than or equal to 0, and the shift t is obtained based on second information.

Between communications devices, other information may be carried in the control information or the data information that needs to be transmitted on the channel. For ease of description and distinction from the first information, the information is referred to as the second information in the present invention. The second information may be one or a combination of time domain information, frequency domain information, subcarrier information, redundancy version information, antenna port information, or the like. The time domain information may include a system frame number (system frame number, SFN), a transmission period, and the like. The frequency domain information may include a frequency, a frequency number, and the like. The subcarrier information may include a subcarrier number and the like. The redundancy version information may include a redundancy version number, a quantity of repetition times, and the like. The antenna port information may include an antenna port number and the like.

The shift t may be obtained based on the second information, and there may be a correspondence between the second information and the shift t. For example, when the second information is a system frame number, the shift t may be corresponding to the least significant 2 bits of the system frame number. Table 1 illustrates a correspondence between the least significant 2 bits of the SFN and the shift t.

**Table 1**

| Least significant 2 bits of SFN | Shift t |
|---|---|
| 00 | 0 |
| 01 | 1 |
| 10 | 2 |
| 11 | 3 |

If a communications device at a transmit end needs to notify a communications device at a receive end of the second information, the shift t may be determined based on the second information, and t is less than or equal to z.

The communications device at a transmit end separately performs t-bit cyclic shift on each bit segment $C_i$ in the bit sequence C, where each $C_i$ includes z bits $[c_{i,0}, c_{i,1}, K, c_{i,z} -1]$, in other words, t-bit cyclic shift is performed on every z bits to obtain the bit sequence $C^t$. The cyclic shift herein may be in a rightward direction or a leftward direction, and cyclic shift is performed in a same direction on each bit segment. Correspondingly, the communications device at a receive end performs reverse cyclic shift. For example, if the cyclic shift at the transmit end is in the rightward direction, the communications device at a receive end performs cyclic shift in the leftward direction.

Performing t-bit cyclic shift on every z bits may be performing t-bit cyclic shift on all bits in every z bits, or performing t-bit cyclic shift on some bits in every z bits.

In an implementation, t-bit cyclic shift may be performed on all bits in every z bits. Using $C_i$ as an example, if $C_i$ includes z bits $[c_{i,0}, c_{i,1}, K, c_{i,z-1}]$, $C_i^t = t \cdot C_i$, where t is a circular permutation matrix of size z*z whose offset is t, in other words, the circular permutation matrix is obtained by circularly shifting an identity matrix of size z*z to the right t times. For example, after 1-bit cyclic shift is performed on $C_i$, $C_i^1 = [c_{i,z-1}, c_{i,0}, c_{i,1}, K, c_{i,z-2}]$.

In another implementation, cyclic shift may be performed on some bits in every z bits. In this manner, f bits in the z bits may be fixed, f is an integer greater than 0 and less than z, and t-bit cyclic shift is performed on remaining z-f bits. In this manner, t needs to be less than or equal to (z-f).

Using z=5 as an example, if $C_i$ includes 5 bits $[c_{i,0}, c_{i,1}, c_{i,2}, c_{i,3}, c_{i,4}]$ and positions of $c_{i,0}$ and $c_{i,2}$ are fixed, after 2-bit cyclic shift is performed on $C_i$, $C_{i,(0,2)}^2 = [c_{i,0}, c_{i,3}, c_{i,2}, c_{i,4}, c_{i,1}]$, where $C_{i,(0,2)}^2$ indicates a sequence obtained after the 2-bit cyclic shift is performed if the positions of $c_{i,0}$ and $c_{i,2}$ in $C_i$ are fixed.

In this manner, in each $C_i$ in the bit sequence C, a quantity of fixed bits needs to be the same as a quantity of positions of the fixed bits.

Further, if t has Q different values in the correspondence between the second information and the shift t, and the shift t and the lifting factor z meet z mod Q+nQ>0, where Q is an integer greater than 0 and n is an integer greater than or equal to 0, (z mod Q+nQ) bits need to be selected from every z bits as fixed bits that are not subjected to cyclic shift, in other words, some bits, namely, (z-f) bits in every z bits are subjected to cyclic shift, and f = (z mod Q+nQ) Similarly, in this manner, in each $C_i$ in the bit sequence C, the quantity of fixed bits needs to be the same as the positions of the fixed bits.

303. Perform LDPC encoding on the bit sequence $C^t$ obtained in step 302 to obtain a bit sequence $D^t$.

The bit sequence $D^t$ is an LDPC code word. After the bit sequence C is LDPC encoded, a bit sequence D is obtained.

The bit sequence $C^t$ is obtained by performing cyclic shift according to the shift t, a length of $C^t$ is the same as that of C, and a length of the bit sequence $D^t$ obtained through the LDPC encoding is the same as that of D, $D^t$ implicitly carries the second information corresponding to the shift t, and a length of control information or data information that needs to be transmitted is not changed after encoding.

Further, the communications device at a transmit end performs processing such as rate matching and modulation on the bit sequence $D^t$ to obtain a signal corresponding to the bit sequence $D^t$, and the communications device at a transmit end sends the signal on a channel. The communications device at a receive end receives the signal corresponding to the bit sequence $D^t$, and may usually obtain a soft value sequence corresponding to the bit sequence $D^t$, for example, a second soft value sequence corresponding to the bit sequence $D^t$. The bit sequence $C^t$ may be obtained by decoding the second soft value sequence corresponding to the bit sequence $D^t$.

The communications device at a receive end may obtain redundancy check bits from $C^t$ to perform redundancy check. Because $C^t$ is obtained by performing cyclic shift, the redundancy check may fail. The communications device at a receive end may select a different shift value n to perform n-bit reverse cyclic shift on $C^t$ for one or more times to obtain a bit sequence $C^{(t-n)}$, where n is an integer greater than 0, and obtain redundancy check bits from the bit sequence $C^{(t-n)}$ to perform redundancy check until the redundancy check succeeds. Each time n may be different. When a value of n is t, the redundancy check succeeds. Therefore, the communications device at a receive end may obtain a shift t of the communications device at a transmit end in an LDPC code word, and further obtain, based on the t, the second information corresponding to the t.

For example, the second information is a system frame number SFN. If a relationship between least significant 2 bits of the SFN and the shift t is shown in Table 1, the communications device at a transmit end may determine the shift t based on the SFN sent by a signal.

Using z=4 as an example, it is assumed that the bit sequence C is [0110 1001 1101], and includes three bit segments, where $C_0$ is 0110, $C_1$ is 1001, and $C_2$ is 1101. Assuming that a system frame number sent by the signal is 122, the shift t is an initial shift $t_I$ and has a value of 2. In this case, 2-bit cyclic shift is performed on every 4 bits in the bit sequence C to obtain a bit sequence $C^2$=[1001 0110 0111], that is, $C_0^2 = 1001$, $C_1^2 = 0110$, $C_2^2 = 0111$.

Using z=5 as another example, it is assumed that the bit sequence C is [10110 01001 11101], and includes three bit segments, where $C_0$ is 10110, $C_1$ is 01001, and $C_2$ is 01001. Assuming that a system frame number sent by the signal is 122, the shift t is an initial shift $t_I$ and has a value of 2. In this case, 2-bit cyclic shift is performed on every five bits in the bit sequence C. One bit in every z bits is fixed, for example, the first bit is fixed to obtain a bit sequence $C^2$=[11001 00110 10111], that is, $C_{0,(0)}^2 = 11001$, $C_{1,(0)}^2 = 00110$, $C_{2,(0)}^2 = 10111$.

It should be noted that what described above are merely examples for easy understanding, and the examples do not constitute a limitation on the present invention.

The communications device at a receive end may determine a shift t=2 through reverse cyclic shift and redundancy check for one or more times, and then learn that the least significant 2 bits of the SFN are 10.

According to the method provided in this embodiment of the present invention, information that needs to be transmitted by a communications device is carried in an encoded LDPC code word through cyclic shift, thereby reducing system overheads.

Further, based on the foregoing embodiment, the communications device at a transmit end may further perform cyclic shift on the bit sequence C based on a shift (t+d) to obtain a bit sequence $C^{t+d}$. d is an integer greater than 0 and is obtained based on third information. The third information is similar to the second information, and the third information may also be one or a combination of time domain information, frequency domain information, subcarrier information, redundancy version information, or antenna port information.

Low-density parity-check LDPC encoding is performed on the bit sequence $C^{t+d}$ to obtain a bit sequence $D^{t+d}$. The bit sequence $D^{t+d}$ is used by the communications device at a receive end to perform soft value combination decoding.

The communications device at a transmit end performs processing such as rate matching and modulation on the bit sequence $D^{t+d}$ to obtain a signal corresponding to the bit sequence $D^{t+d}$, and the communications device at a transmit end sends the signal on a channel.

After receiving the signal corresponding to the bit sequence $D^{t+d}$, the communications device at a receive end may usually obtain a soft value sequence corresponding to the bit sequence $D^{t+d}$.

A difference d between the shift (t+d) and the shift t is known to the communications device at a receive end. For example, the signal corresponding to the bit sequence $D^t$ is sent at a moment corresponding to t, and the signal corresponding to the bit sequence $D^{t+d}$ is sent at a moment corresponding to t+d. The communications device at a receive end respectively receives two signals at the moment corresponding to t and the moment corresponding to t+d. Even if the moment corresponding to t is unknown, a difference between the two moments can be obtained, so that the difference d between the shifts may be obtained. For another example, the signal corresponding to the bit sequence $D^t$ is sent on an antenna port corresponding to t, and the signal corresponding to the bit sequence $D^{t+d}$ is sent at an antenna port corresponding to t+d. The communications device at a receive end may obtain a difference between the two antenna ports, so that the difference d between the shifts is obtained. It should be noted that only examples are provided herein for description, and the examples do not constitute a limitation on the present invention.

The communications device at a receive end may perform, based on the difference d of the shifts and the lifting factor z, d-bit reverse cyclic shift on a soft value sequence corresponding to the bit sequence $D^{t+d}$ to obtain another soft value sequence corresponding to the bit sequence $D^t$, for example, a third soft value sequence corresponding to the bit sequence $D^t$. Performing soft value combination on the second soft value sequence and the third soft value sequence corresponding to the bit sequence $D^t$ to obtain a first soft value sequence, and the first soft value sequence may be decoded to obtain the bit sequence $C^t$.

The communications device at a receive end may obtain redundancy check bits from $C^t$ to perform redundancy check. Because $C^t$ is obtained by cyclic shift, the redundancy check may fail. The communications device at a receive end may select a different shift value n to perform n-bit reverse cyclic shift on $C^t$ for one or more times to obtain a bit sequence $C^{(t-n)}$, where n is an integer greater than 0, and obtain redundancy check bits from the bit sequence $C^{(t-n)}$ to perform redundancy check until the redundancy check succeeds. Each time n may be different. When a value of n is t, the redundancy check succeeds. Therefore, the communications device at a receive end may obtain a shift t of the communications device at a transmit end in an LDPC code word, and further obtain, based on the t, the second information corresponding to the t.

For example, the second information is still used as a transmission period. The first information needs to be transmitted in four consecutive periods.

Using z=6 as an example, if Q=4, a signal corresponding to the bit sequence C is transmitted once in every period and is transmitted for 4 times in total. Assuming that n=0, no cyclic shift is performed on every 6 bits in the bit sequence C, that is, 2 bits in each $C_i$ are fixed and are not cyclic shifted, and positions of the fixed 2 bits in every 6 bits are unchanged. The bit sequence C is [100110 011001 110101] and includes three bit segments, where $C_0$ is 100110, $C_1$ is 011001, and $C_2$ is 110101. Because two bits need to be fixed, the first bit (the bit 0) and the second bit may be fixed. For a transmission period 0, cyclic shift may not be performed. For a transmission period 1, 1-bit cyclic shift is performed on the bit sequence C to obtain a bit sequence $C^1$=[100011 011100 110110]. For a transmission period 2, 2-bit cyclic shift is performed on the bit sequence C to obtain a bit sequence $C^2$=[110001 001110 100111]. For a transmission period 3, 3-bit cyclic shift is performed on the bit sequence C to obtain a bit sequence $C^3$=[110100 001011

110011].

The communications device at a receive end may separately decode and check a soft value sequence of any one of four bit sequences $D^0$, $D^1$, $D^2$, and $D^3$ after receiving the soft value sequence to obtain a transmission period number in the soft value sequence, and may alternatively perform combination decoding on a plurality of soft value sequences of the four bit sequences. For example, for D' and $D^3$, based on D', because a receiving moment of $D^3$ is two periods apart from D', a soft value sequence, obtained by performing 2-bit reverse cyclic shift on the soft value sequence of $D^3$, and the soft value sequence of $D^1$ are combined and decoded, and then redundancy checked, and a shift t=1 may be finally determined, thereby obtaining a transmission period number of 1 of $D^1$.

It should be noted that the foregoing implementations are only examples, and the examples do not constitute a limitation on the present invention.

In this manner, the communications device at a receive end may obtain a gain of soft value combination decoding without increasing system transmission overheads and decoding complexity.

In another embodiment of the present invention, LDPC encoding may be performed first on a bit sequence C to which redundancy check bits are added, and then cyclic shift is performed based on a shift t and a lifting factor z. FIG. 4 is a flowchart of an information processing method according to an embodiment of the present invention, and the information processing method may be applied to a channel on which LDPC encoding is used, and includes:

401. Add redundancy check bits to a bit sequence A corresponding to first information to obtain a bit sequence C.

For step 401, refer to the description of step 301 in the foregoing embodiment. Details are not described herein again.

402. Perform LDPC encoding on the bit sequence C obtained in step 401 to obtain a bit sequence D.

The bit sequence C is LDPC encoded to obtain the bit sequence D, the bit sequence D may be represented as a sequence $[D_0,D_1,D_2,D_3,...,D_{nb-1}]$, and each bit segment $D_i$ includes z bits. The bit sequence D is an LDPC code word.

403. Perform, based on a shift t and a lifting factor z, cyclic shift on the bit sequence D obtained in step 402 to obtain a bit sequence $D^t$, where t is an integer greater than or equal to 0, and the t is obtained based on second information.

For an implementation of performing cyclic shift on the bit sequence D in step 403, refer to the description of step 302 in the foregoing embodiment. A difference is that in step 302, the cyclic shift is performed on the bit sequence C before encoding to obtain $C^t$, but in step 403, cyclic shift is performed on the bit sequence D after encoding to obtain $D^t$. The bit sequence $D^t$ is still an LDPC code word. This is proven as follows:

It is assumed that an LDPC matrix with a QC structure is represented in the following form (1):

$$\begin{bmatrix} H_{0,0} & H_{0,1} & H_{0,2} & L & H_{0,nb-1} \\ H_{1,0} & H_{1,1} & H_{1,2} & L & H_{1,nb-1} \\ H_{2,0} & H_{2,1} & H_{0,2} & L & H_{0,nb-1} \\ M & M & M & O & M \\ H_{mb-1,0} & H_{mb-1,1} & H_{mb-1,2} & L & H_{mb-1,nb-1} \end{bmatrix} \quad (1)$$

Each element $H_{p,q}$ represents a matrix of z*z in size.

Based on characteristics of the LDPC matrix, the following relationship is met:

$$\begin{bmatrix} H_{0,0} & H_{0,1} & H_{0,2} & L & H_{0,nb-1} \\ H_{1,0} & H_{1,1} & H_{1,2} & L & H_{1,nb-1} \\ H_{2,0} & H_{2,1} & H_{0,2} & L & H_{0,nb-1} \\ M & M & M & O & M \\ H_{mb-1,0} & H_{mb-1,1} & H_{mb-1,2} & L & H_{mb-1,nb-1} \end{bmatrix} \begin{bmatrix} D_0 \\ D_1 \\ D_2 \\ M \\ D_{nb-1} \end{bmatrix} = \begin{bmatrix} 0 \\ 0 \\ 0 \\ M \\ 0 \end{bmatrix} \quad (2)$$

In the equation (2), each 0 on the right of the equal sign represents an all-zero bit segment with a length of z.

Each bit segment $D_i$ in the bit sequence D is performed t-bit cyclic shifting to obtain a bit sequence $D^t$, where the bit sequence $D^t$ may be represented as a sequence $[D_0,D_1,D_2,D_3,...,D_{nb-1}]$, each bit segment $D_i^t$ includes z bits, and the bit segment $D_i^t$ is obtained by performing t-bit cyclic shift on the bit segment $D_i$.

Therefore, the following relationship between the bit sequence D$^t$ and the bit sequence D is met:

$$
\begin{bmatrix}
t & -1 & -1 & L & -1 \\
-1 & t & -1 & L & -1 \\
-1 & -1 & t & L & -1 \\
M & M & M & O & M \\
-1 & -1 & -1 & L & t
\end{bmatrix}
\begin{bmatrix}
D_0 \\
D_1 \\
D_2 \\
M \\
D_{nb-1}
\end{bmatrix}
=
\begin{bmatrix}
D_0^t \\
D_1^t \\
D_2^t \\
M \\
D_{nb-1}^t
\end{bmatrix}
\quad (3)
$$

In the equation (3), each element whose value is -1 on the left of the equal sign represents an all-zero matrix of z*z, and an element whose value is t represents a circular permutation matrix of size z*z whose offset is t.

For the equation (3), both sides are left multiplied by the LDPC matrix (1) to obtain

$$
\begin{bmatrix}
H_{0,0} & H_{0,1} & H_{0,2} & L & H_{0,nb-1} \\
H_{1,0} & H_{1,1} & H_{1,2} & L & H_{1,nb-1} \\
H_{2,0} & H_{2,1} & H_{0,2} & L & H_{0,nb-1} \\
M & M & M & O & M \\
H_{mb-1,0} & H_{mb-1,1} & H_{mb-1,2} & L & H_{mb-1,nb-1}
\end{bmatrix}
\begin{bmatrix}
t & -1 & -1 & L & -1 \\
-1 & t & -1 & L & -1 \\
-1 & -1 & t & L & -1 \\
M & M & M & O & M \\
-1 & -1 & -1 & L & t
\end{bmatrix}
\begin{bmatrix}
D_0 \\
D_1 \\
D_2 \\
M \\
D_{nb-1}
\end{bmatrix}
$$

$$
=
\begin{bmatrix}
H_{0,0} & H_{0,1} & H_{0,2} & L & H_{0,nb-1} \\
H_{1,0} & H_{1,1} & H_{1,2} & L & H_{1,nb-1} \\
H_{2,0} & H_{2,1} & H_{0,2} & L & H_{0,nb-1} \\
M & M & M & O & M \\
H_{mb-1,0} & H_{mb-1,1} & H_{mb-1,2} & L & H_{mb-1,nb-1}
\end{bmatrix}
\begin{bmatrix}
D_0^t \\
D_1^t \\
D_2^t \\
M \\
D_{nb-1}^t
\end{bmatrix}
\quad (4)
$$

The equation (4) is transformed to obtain

$$
\begin{bmatrix}
t & -1 & -1 & L & -1 \\
-1 & t & -1 & L & -1 \\
-1 & -1 & t & L & -1 \\
M & M & M & O & M \\
-1 & -1 & -1 & L & t
\end{bmatrix}
\begin{bmatrix}
H_{0,0} & H_{0,1} & H_{0,2} & L & H_{0,nb-1} \\
H_{1,0} & H_{1,1} & H_{1,2} & L & H_{1,nb-1} \\
H_{2,0} & H_{2,1} & H_{0,2} & L & H_{0,nb-1} \\
M & M & M & O & M \\
H_{mb-1,0} & H_{mb-1,1} & H_{mb-1,2} & L & H_{mb-1,nb-1}
\end{bmatrix}
\begin{bmatrix}
D_0 \\
D_1 \\
D_2 \\
M \\
D_{nb-1}
\end{bmatrix}
$$

$$
=
\begin{bmatrix}
H_{0,0} & H_{0,1} & H_{0,2} & L & H_{0,nb-1} \\
H_{1,0} & H_{1,1} & H_{1,2} & L & H_{1,nb-1} \\
H_{2,0} & H_{2,1} & H_{0,2} & L & H_{0,nb-1} \\
M & M & M & O & M \\
H_{mb-1,0} & H_{mb-1,1} & H_{mb-1,2} & L & H_{mb-1,nb-1}
\end{bmatrix}
\begin{bmatrix}
D_0^t \\
D_1^t \\
D_2^t \\
M \\
D_{nb-1}^t
\end{bmatrix}
\quad (5)
$$

thereby obtaining

$$\begin{bmatrix} H_{0,0} & H_{0,1} & H_{0,2} & \mathrm{L} & H_{0,nb-1} \\ H_{1,0} & H_{1,1} & H_{1,2} & \mathrm{L} & H_{1,nb-1} \\ H_{2,0} & H_{2,1} & H_{0,2} & \mathrm{L} & H_{0,nb-1} \\ \mathrm{M} & \mathrm{M} & \mathrm{M} & \mathrm{O} & \mathrm{M} \\ H_{mb-1,0} & H_{mb-1,1} & H_{mb-1,2} & \mathrm{L} & H_{mb-1,nb-1} \end{bmatrix} \begin{bmatrix} D_0^t \\ D_1^i \\ D_2^t \\ \mathrm{M} \\ D_{nb-1}^t \end{bmatrix} = \begin{bmatrix} 0 \\ 0 \\ 0 \\ \mathrm{M} \\ 0 \end{bmatrix} \qquad (6)$$

It can be learned that after the LDPC code word, namely, the bit sequence D is subjected to t-bit cyclic shift, an LDPC code word, namely, $D^t$, is still obtained.

Therefore, $D^t$ implicitly carries the second information corresponding to the shift t, and a length of control information or data information that needs to be transmitted is not changed after encoding.

Further, a communications device at a transmit end performs processing such as rate matching and modulation on the bit sequence $D^t$ to obtain a signal corresponding to the bit sequence $D^t$, and the communications device at a transmit end sends the signal on a channel. A communications device at a receive end receives the signal corresponding to the bit sequence $D^t$, and may usually obtain a soft value sequence corresponding to the bit sequence $D^t$, for example, a second soft value sequence corresponding to the bit sequence $D^t$. A bit sequence $C^t$ may be obtained by decoding the second soft value sequence corresponding to the bit sequence $D^t$.

The communications device at a receive end may perform cyclic shift and redundancy check on $C^t$, that is, select a different shift value n to perform n-bit reverse cyclic shift for one or more times on $C^t$ to obtain a bit sequence $C^{(t-n)}$, where n is an integer greater than 0, and obtain redundancy check bits from the bit sequence $C^{(t-n)}$ to perform redundancy check until the redundancy check succeeds.

The communications device at a receive end may alternatively perform cyclic shift first and then perform decoding and redundancy check, that is, select a different shift value n to perform n-bit reverse cyclic shift on $D^t$ for one or more times to obtain a bit sequence $D^{(t-n)}$, where n is an integer greater than 0, decode the bit sequence $D^{(t-n)}$ to obtain a bit sequence $C^{(t-n)}$, and obtain redundancy check bits from the bit sequence $C^{(t-n)}$ to perform redundancy check until the redundancy check succeeds.

Each time n may be different. When a value of n is t, the redundancy check succeeds. Therefore, the communications device at a receive end may obtain a shift t of the communications device at a transmit end in an LDPC code word, and further obtain the second information based on the t. According to the method provided in this embodiment of the present invention, information that needs to be transmitted by a communications device is carried in an encoded LDPC code word through cyclic shift, thereby reducing system overheads.

Further, based on the foregoing embodiment, the communications device at a transmit end may further perform cyclic shift on the bit sequence D based on a shift (t+d) to obtain a bit sequence $D^{t+d}$. d is an integer greater than 0 and is obtained based on third information. The third information is similar to the second information, and the third information may also be one or a combination of time domain information, frequency domain information, subcarrier information, redundancy version information, or antenna port information. The bit sequence $D^{t+d}$ may be used by the communications device at a receive end to perform soft combination decoding.

The communications device at a transmit end performs processing such as rate matching and modulation on the bit sequence $D^{t+d}$ to obtain a signal corresponding to the bit sequence $D^{t+d}$, and the communications device at a transmit end sends the signal on a channel.

After receiving the signal corresponding to the bit sequence $D^{t+d}$, the communications device at a receive end may usually obtain a soft value sequence corresponding to the bit sequence $D^{t+d}$.

A difference d between the shift (t+d) and the shift t is known to the communications device at a receive end. For example, the signal corresponding to the bit sequence $D^t$ is sent at a moment corresponding to t, and the signal corresponding to the bit sequence $D^{t+d}$ is sent at a moment corresponding to t+d. The communications device at a receive end respectively receives two signals at the moment corresponding to t and the moment corresponding to t+d. Even if the moment corresponding to t is unknown, a difference between the two moments can be obtained, so that the difference d between the shifts may be obtained. For another example, the signal corresponding to the bit sequence $D^t$ is sent on an antenna port corresponding to t, and the signal corresponding to the bit sequence $D^{t+d}$ is sent on an antenna port corresponding to t+d. The communications device at a receive end may obtain a difference between the two antenna ports, so that the difference d between the shifts is obtained. It should be noted that only examples are provided herein for description, and the examples do not constitute a limitation on the present invention.

The communications device at a receive end may perform, based on the difference d of the shifts and the lifting factor z, d-bit reverse cyclic shift on a soft value sequence corresponding to the bit sequence $D^{t+d}$ to obtain another soft value sequence corresponding to the bit sequence $D^t$, for example, a third soft value sequence corresponding to the bit sequence $D^t$. Soft values from the second soft value sequence and the third soft value sequence corresponding to the bit sequence $D^t$ are combined to obtain a first soft value sequence, and the first soft value sequence may be decoded to obtain the bit sequence $C^t$.

The communications device at a receive end may obtain redundancy check bits from $C^t$ to perform redundancy check. Because $C^t$ is obtained by performing cyclic shift, the redundancy check may fail. The communications device at a receive end may select a different shift value n to perform n-bit reverse cyclic shift on $C^t$ for one or more times to obtain a bit sequence $C^{(t-n)}$, where n is an integer greater than 0, and obtain redundancy check bits from the bit sequence $C^{(t-n)}$ to perform redundancy check until the redundancy check succeeds. Each time n may be different. When a value of n is t, the redundancy check succeeds. Therefore, the communications device at a receive end may obtain a shift t of the communications device at a transmit end in an LDPC code word, and further obtain, based on the t, the second information corresponding to the t.

In this manner, the communications device at a receive end may obtain a gain of soft value combination decoding without increasing system transmission overheads and decoding complexity.

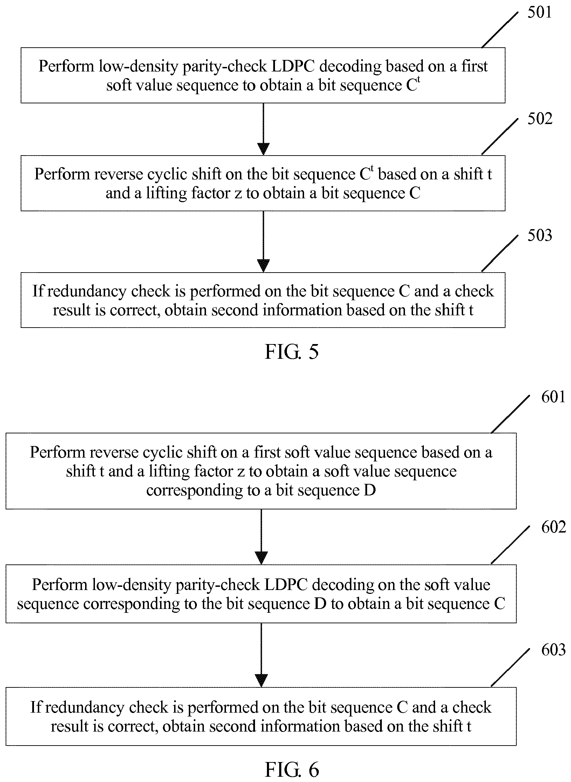

FIG. 5 is a schematic flowchart of an information processing method according to another embodiment of the present invention, and the method may be applied to a channel on which LDPC encoding is used, and includes:

501. Perform low-density parity-check LDPC decoding based on a first soft value sequence to obtain a bit sequence $C^t$.

The first soft value sequence may be a second soft value sequence corresponding to a $D^t$, or a sequence obtained by combining a second soft value sequence corresponding to a bit sequence $D^t$ with a third soft value sequence corresponding to the bit sequence $D^t$.

The third soft value sequence corresponding to the bit sequence $D^t$ is obtained by performing reverse cyclic shift on a soft value sequence corresponding to a bit sequence $D^{t+d}$ based on a shift d and a lifting factor z.

502. Perform reverse cyclic shift on the bit sequence $C^t$ based on a shift t and a lifting factor z to obtain a bit sequence C, where t is an integer greater than or equal to 0.

503. If redundancy check is performed on the bit sequence C and a check result is correct, obtain second information based on the shift t.

The second information includes at least one of the following information: time domain information, frequency domain information, subcarrier information, redundancy version information, or antenna port information. Because a process of signal processing by a communications device at a receive end is an inverse process performed by a communications device at a transmit end, the second information, bit sequences C, $C^t$, D, and $D^t$, and the like have same meanings as those in the foregoing embodiments of the communications device at a transmit end.

For a decoding part, refer to the descriptions of processing by the communications device at a receive end in the foregoing embodiments. Details are not described herein again.

FIG. 6 is a schematic flowchart of an information processing method according to another embodiment of the present invention. Alternatively, a shift t may be determined first, and then an LDPC code is decoded after being reversely circularly shifted by t bits. The method may be applied to a channel on which LDPC encoding is used, and includes:

601. Perform reverse cyclic shift on a first soft value sequence based on a shift t and a lifting factor z to obtain a soft value sequence corresponding to a bit sequence D, where t is an integer greater than or equal to 0.

The first soft value sequence may be a second soft value sequence corresponding to a $D^t$, or a sequence obtained by combining a second soft value sequence corresponding to a bit sequence $D^t$ with a third soft value sequence corresponding to the bit sequence $D^t$.

The third soft value sequence corresponding to the bit sequence $D^t$ is obtained by performing reverse cyclic shift on a soft value sequence corresponding to a bit sequence $D^{t+d}$ based on a shift d and a lifting factor z.

602. Perform low-density parity-check LDPC decoding on the soft value sequence corresponding to the bit sequence D to obtain a bit sequence C.

603. If redundancy check is performed on the bit sequence C and a check result is correct, obtain second information based on the shift t.

The second information includes at least one of the following information: time domain information, frequency domain information, subcarrier information, redundancy version information, or antenna port information. Because a process of signal processing by a communications device at a receive end is an inverse process performed by a communications device at a transmit end, the second information, bit sequences C, $C^t$, D, and $D^t$, and the like have same meanings as those in the foregoing embodiments of the communications device at a transmit end.

For a decoding part, refer to the descriptions of processing by the communications device at a receive end in the foregoing embodiments. Details are not described herein again.

In a communications system, before the communications device at a receive end performs the foregoing method, the method may further include: receiving an LDPC code, demodulating a bit sequence, and performing de-interleaving and rate de-matching to obtain soft values of the LDPC code.

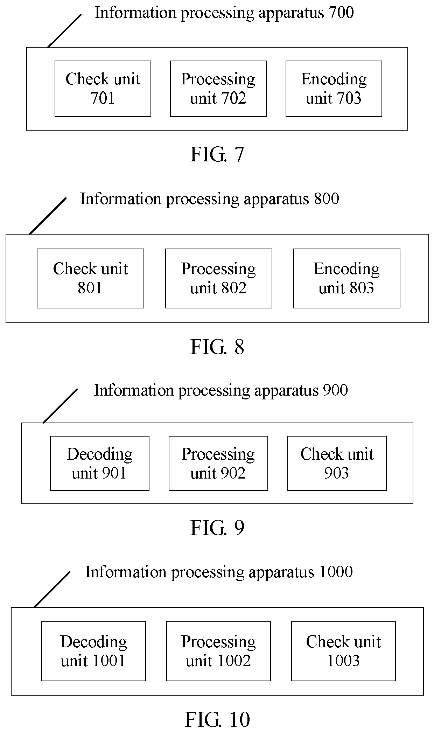

FIG. 7 is a schematic structural diagram of an information processing apparatus 700. The apparatus 700 may be configured to implement the method embodiment shown in FIG. 3. Refer to the description of the foregoing method embodiment. Details are not described herein again. The apparatus 700 may include a check unit 701, a processing unit 702, and an encoding unit 703.

The check unit 701 is configured to add redundancy check bits to a bit sequence A corresponding to first information to obtain a bit sequence C.

The processing unit 702 is configured to perform cyclic shift on the bit sequence C based on a shift t and a lifting factor z to obtain a bit sequence $C^t$, where t is an integer greater than or equal to 0, and the shift t is obtained based on second information.

The encoding unit 703 is configured to perform LDPC encoding on the bit sequence $C^t$ obtained by the processing unit 702 to obtain a bit sequence $D^t$.

FIG. 8 is a schematic structural diagram of an information processing apparatus 800. The apparatus may be used in the method embodiment shown in FIG. 4. Refer to the description of the foregoing method embodiment. Details are not described herein again. The apparatus 800 may include a check unit 801, a processing unit 802, and an encoding unit 803.

The check unit 801 is configured to add redundancy check bits to a bit sequence A corresponding to first information to obtain a bit sequence C.

The encoding unit 803 is configured to perform LDPC encoding on the bit sequence C obtained by the check unit 801 to obtain a bit sequence D.

The processing unit 802 is configured to perform, based on a shift t and a lifting factor z, cyclic shift on the bit sequence D obtained by the encoding unit 803 to obtain a bit sequence $D^t$, where t is an integer greater than or equal to 0, and the t is obtained based on second information.

FIG. 9 is a schematic structural diagram of an information processing apparatus 900. The apparatus 900 may be configured to implement the method embodiment shown in FIG. 5. Refer to the description of the foregoing method embodiment. Details are not described herein again.

The apparatus 900 may include a decoding unit 901, a processing unit 902, and a check unit 903. The decoding unit 901 is configured to perform low-density parity-check LDPC decoding based on a first soft value sequence to obtain a bit sequence $C^t$.

The processing unit 902 is configured to perform reverse cyclic shift on the bit sequence $C^t$ based on a shift t and a lifting factor z to obtain a bit sequence C, where t is an integer greater than or equal to 0.

The check unit 903 is configured to perform redundancy check on the bit sequence C obtained by the processing unit 902.

The processing unit 902 is further configured to: if the check unit 903 performs redundancy check on the bit sequence C and a check result is correct, obtain second information based on the shift t.

FIG. 10 is a schematic structural diagram of an information processing apparatus 1000. The apparatus 1000 may be configured to implement the method embodiment shown in FIG. 6. Refer to the description of the foregoing method embodiment. Details are not described herein again. The apparatus 1000 may include a decoding unit 1001, a processing unit 1002, and a check unit 1003.

The processing unit 1002 is configured to perform reverse cyclic shift on a first soft value sequence based on a shift t and a lifting factor z to obtain a soft value sequence corresponding to a bit sequence D, where t is an integer greater than or equal to 0.

The decoding unit 1001 is configured to perform low-density parity-check LDPC decoding on the soft value sequence, obtained by the processing unit 1002, corresponding to the bit sequence D to obtain a bit sequence C.

The check unit 1003 is configured to perform redundancy check on the bit sequence C obtained by the decoding unit 1001.

The processing unit 1002 is further configured to: if the check unit 1003 performs redundancy check on the bit sequence C and a check result is correct, obtain second information based on the shift t.

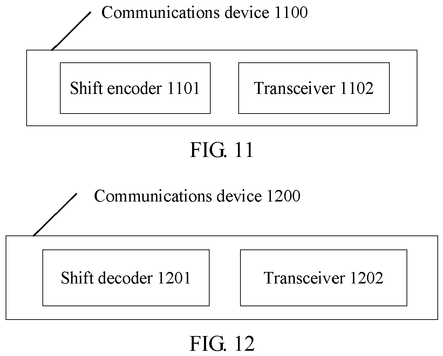

FIG. 11 is a schematic structural diagram of a communications device. The communications device may be applied to a communications system. The communications device 1100 may include a shift encoder 1101 and a transceiver 1102. The shift encoder 1101 may also be referred to as a shift encoding unit, a shift encoding circuit, or the like, is configured to add check bits to, perform cyclic shift on, and encode a bit sequence A corresponding to first information, and may include the apparatus 700 in FIG. 7 or the apparatus 800 in FIG. 8. The transceiver 1102 may also be referred to as a transceiver unit, a transceiver, or a transceiver circuit, and is mainly configured to transmit and receive a radio frequency signal, for example, configured to send a modulated LDPC code, such as the signal corresponding to the bit sequence $D^t$ in the foregoing embodiments. The communications device 1100 may further include another component, such as an interleaver or a modulator.

It should be noted that the communications device 1100 may include one or more memories and one or more processors. The memory stores an instruction, and the processor is coupled to the memory and is configured to invoke the instruction in the memory to perform the steps described in the foregoing method embodiments. The memory may further include another instruction for the processor to invoke and execute a function of another part of the communications device 1100, such as interleaving and modulation.

FIG. 12 is a schematic structural diagram of a communications device. The communications device may be applied to a communications system. The communications device 1200 may include a shift decoder 1201 and a transceiver 1202. The shift decoder 1201 may also be referred to as a shift decoding unit or a shift decoding circuit, is configured to perform decoding, shifting, and checking on a received soft value sequence, and may include the apparatus 900 in FIG. 9 or the apparatus 1000 in FIG. 10. The transceiver 1202 may also be referred to as a transceiver unit, a transceiver, or a transceiver circuit, and is mainly configured to transmit and receive a radio frequency signal, for example, configured to receive the signal corresponding to the bit sequence $D^t$ in the foregoing embodiments. The communications device 1200 may further include another component, such as a de-interleaver or a demodulator.

It should be noted that the communications device 1200 may include one or more memories and one or more processors. The memory stores an instruction, and the processor is coupled to the memory and is configured to invoke the instruction in the memory to perform the steps described in the foregoing method embodiments. The memory may further include another instruction for the processor to invoke and execute a function of another part of the communications device 1200, such as de-interleaving and demodulation.

A person skilled in the art may further understand that various illustrative logical blocks (illustrative logic block) and steps (step) that are listed in the embodiments of the present invention may be implemented by using electronic hardware, computer software, or a combination thereof. Whether the functions are implemented by using hardware or software depends on particular applications and a design requirement of an entire system. A person skilled in the art may use various methods to implement the described functions for each particular application, but it should not be considered that the implementation goes beyond the scope of the embodiments of the present invention.

The various illustrative logical units and circuits described in the embodiments of the present invention may implement or operate the described functions by using a general-purpose processor, a digital signal processor, an application-specific integrated circuit (ASIC), a field programmable gate array (FPGA) or another programmable logical apparatus, a discrete gate or transistor logic, a discrete hardware component, or a design of any combination thereof. The general-purpose processor may be a microprocessor. Optionally, the general-purpose processor may also be any conventional processor, controller, microcontroller, or state machine. The processor may also be implemented by a combination of computing apparatuses, such as a digital signal processor and a microprocessor, a plurality of microprocessors, one or more microprocessors with a digital signal processor core, or any other similar configuration.

Steps of the methods or algorithms described in the embodiments of the present invention may be directly embedded into hardware, an instruction executed by a processor, or a combination thereof. The memory may be a RAM memory, a flash memory, a ROM memory, an EPROM memory, an EEPROM memory, a register, a hard disk, a removable hard disk, a CD-ROM, or a storage medium of any other form in the art. For example, the memory may be connected to a processor, so that the processor may read information from the memory and write information to the memory. Optionally, the memory may further be integrated into a processor. The processor and the memory may be disposed in an ASIC, and the ASIC may be disposed in UE. Optionally, the processor and the memory may be disposed in different components of the UE.

With descriptions of the foregoing embodiments, a person skilled in the art may clearly understand that the present invention may be implemented by hardware, firmware or a combination thereof. When the present invention is implemented by a software program, the present invention may be all or partially implemented in a form of a computer program product. The computer program product includes one or more computer instructions. When the computer instructions are loaded and executed on a computer, the procedures or functions according to the embodiments of the present invention are all or partially generated. When the present invention is implemented by a software program, the foregoing functions may be stored in a computer readable medium or transmitted as one or more instructions or code in the computer readable medium. The computer may be a general-purpose computer, a dedicated computer, a computer network, or another programmable apparatus. The computer instruction may be stored in a computer readable storage medium, or may be transmitted from one computer-readable storage medium to another. The computer-readable medium includes a computer storage medium and a communications medium, where the communications medium includes any medium that enables a computer program to be transmitted from one place to another. The storage medium may be any available medium accessible to a computer. By way of example and without limitation, the computer-readable medium may include a RAM, a ROM, an EEPROM, a CD-ROM, another optical disc storage or disk storage medium, another magnetic storage device, or any other medium that can carry or store expected program code in a form of an instruction or data structure and can be accessed by a computer. In addition, any connection may be appropriately defined as a computer-readable medium. For example, if software is transmitted from a website, a server or another remote source by using a coaxial cable, an optical fiber/cable, a twisted pair, a digital subscriber line (DSL), or wireless technologies such as infrared ray, radio and microwave, the coaxial cable, the optical fiber/cable, the twisted pair, the DSL, or the wireless technologies such as infrared ray, radio and microwave are included in a definition of a medium to which they belong. For example, a disk (Disk) or a disc (disc) used in the present invention is a compact disc (CD), a laser disc, an optical disc, a digital versatile disc (DVD), a floppy disk, or a Blu-ray disc, where the disk generally copies data by a magnetic means, and the disc copies data optically by a laser means. The foregoing combination should also be included in the protection scope of the computer-readable medium.

In summary, what is described above is merely example embodiments of the technical solutions of the present invention, but is not intended to limit the protection scope of the present invention. Any modification, equivalent replacement, or improvement made without departing from the spirit and principle of the present invention shall fall within the protection scope of the present invention.

**Claims**

1. An information processing method, wherein the method comprises:

   adding redundancy check bits to a bit sequence A corresponding to first information to obtain a bit sequence C;
   performing cyclic shift on the bit sequence C based on a shift t and a lifting factor z to obtain a bit sequence $C^t$, wherein t is an integer greater than or equal to 0, and the shift t is obtained based on second information; and
   performing low-density parity-check LDPC encoding on the bit sequence $C^t$ to obtain a bit sequence $D^t$.

2. The method according to claim 1, wherein the performing cyclic shift on the bit sequence C based on a shift t and a lifting factor z to obtain a bit sequence $C^t$ comprises:
   separately performing t-bit cyclic shift on every z bits in the bit sequence C to obtain the bit sequence $C^t$.

3. The method according to claim 2, wherein the performing t-bit cyclic shift on every z bits in the bit sequence C to obtain the bit sequence $C^t$ comprises:

   performing t-bit cyclic shift on all bits in every z bits in the bit sequence C to obtain the bit sequence $C^t$; or
   performing t-bit cyclic shift on (z-f) bits in every z bits in the bit sequence C to obtain the bit sequence $C^t$, wherein t is less than or equal to (z-f).

4. The method according to claim 1, wherein the bit sequence C comprises $n_b$ bit segments, namely, $C_0, C_1, C_2, C_3, ..., C_{n_b-1}$, each bit segment $C_i$ comprises z bits; the bit sequence $C^t$ comprises $n_b$ bit segments, namely, $C_0^t, C_1^t, C_2^t, C_3^t, ..., C_{n_b-1}^t$, and each bit segment $C_i^t$ comprises z bits, wherein the bit segment $C_i^t$ is obtained by performing t-bit cyclic shift on the bit segment $C_i$.

5. An information processing method, wherein the method comprises:

   adding redundancy check bits to a bit sequence A corresponding to first information to obtain a bit sequence C;
   performing low-density parity-check LDPC encoding on the bit sequence C to obtain a bit sequence D; and
   performing cyclic shift on the bit sequence D based on a shift t and a lifting factor z to obtain a bit sequence $D^t$, wherein t is an integer greater than or equal to 0, and the shift t is obtained based on second information.

6. The method according to claim 5, wherein the performing cyclic shift on the bit sequence D based on a shift t and a lifting factor z to obtain a bit sequence $D^t$ comprises:
   separately performing t-bit cyclic shift on every z bits in the bit sequence D to obtain the bit sequence $D^t$.

7. The method according to claim 6, wherein the performing t-bit cyclic shift on every z bits in the bit sequence D to obtain the bit sequence $D^t$ comprises:

   performing t-bit cyclic shift on all bits in every z bits in the bit sequence D to obtain the bit sequence $D^t$; or
   performing t-bit cyclic shift on (z-f) bits in every z bits in the bit sequence D to obtain the bit sequence $D^t$, wherein t is less than or equal to (z-f).

8. The method according to claim 5, wherein the bit sequence D comprises $n_b$ bit segments, namely, $D_0, D_1, D_2, D_3, ..., D_{n_b-1}$, each bit segment $D_i$ comprises z bits, the bit sequence $D^t$ comprises $n_b$ bit segments, namely, $D_0^t, D_1^t, D_2^t, D_3^t, ..., D_{n_b-1}^t$, and each bit segment $D_i^t$ comprises z bits, wherein the bit segment $D_i^t$ is obtained by performing t-bit cyclic shift on the bit segment $D_i$.

9. The method according to any one of claims 1 to 8, wherein the second information comprises at least one of the following information: time domain information, frequency domain information, subcarrier information, redundancy version information, or antenna port information.

10. An information processing method, wherein the method comprises:

    performing reverse cyclic shift on a first soft value sequence based on a shift t and a lifting factor z to obtain a soft value sequence corresponding to a bit sequence D, wherein t is an integer greater than or equal to 0;
    performing low-density parity-check LDPC decoding on the soft value sequence corresponding to the bit sequence D to obtain a bit sequence C; and
    if redundancy check is performed on the bit sequence C and a check result is correct, obtaining second information based on the shift t.

11. The method according to claim 10, wherein the performing reverse cyclic shift on the first soft value sequence based on a shift t and a lifting factor z to obtain a soft value sequence corresponding to a bit sequence D comprises:
    separately performing t-bit reverse cyclic shift on every z bits in the first soft value sequence to obtain a soft value sequence corresponding to the bit sequence D.

12. The method according to claim 11, wherein the performing t-bit reverse cyclic shift on every z bits in the first soft value sequence to obtain a soft value sequence corresponding to the bit sequence D comprises:

    performing t-bit reverse cyclic shift on all bits in every z bits in the first soft value sequence to obtain the soft value sequence corresponding to the bit sequence D; or
    performing t-bit reverse cyclic shift on (z-f) bits in every z bits in the first soft value sequence to obtain the soft value sequence corresponding to the bit sequence D, wherein t is less than or equal to (z-f).

13. An information processing method, wherein the method comprises:

    performing low-density parity-check LDPC decoding based on a first soft value sequence to obtain a bit sequence $C^t$;
    performing reverse cyclic shift on the bit sequence $C^t$ based on a shift t and a lifting factor z to obtain a bit sequence C, wherein t is an integer greater than or equal to 0; and
    if redundancy check is performed on the bit sequence C and a check result is correct, obtaining second information based on the shift t.

14. The method according to any one of claims 10 to 13, wherein the first soft value sequence is a second soft value sequence corresponding to a bit sequence $D^t$, or a sequence obtained by combining a second soft value sequence corresponding to a bit sequence $D^t$ with a third soft value sequence corresponding to the bit sequence $D^t$, wherein the third soft value sequence corresponding to the bit sequence $D^t$ is obtained by performing reverse cyclic shift on a soft value sequence corresponding to a bit sequence $D^{t+d}$ based on a shift d and a lifting factor z.

15. The method according to any one of claims 10 to 14, wherein the second information comprises at least one of the following information: time domain information, frequency domain information, subcarrier information, redundancy version information, or antenna port information.

16. An apparatus, wherein the apparatus comprises:

    a check unit, configured to add redundancy check bits to a bit sequence A corresponding to first information to obtain a bit sequence C;
    a processing unit, configured to perform cyclic shift on the bit sequence C based on a shift t and a lifting factor z to obtain a bit sequence $C^t$, wherein t is an integer greater than or equal to 0, and the shift t is obtained based on second information; and
    an encoding unit, configured to perform low-density parity-check LDPC encoding on the bit sequence $C^t$ to obtain a bit sequence $D^t$.

17. The apparatus according to claim 16, wherein the processing unit is specifically configured to separately perform t-bit cyclic shift on every z bits in the bit sequence C to obtain the bit sequence $C^t$.

**18.** The apparatus according to claim 17, wherein the processing unit is specifically configured to separately perform t-bit cyclic shift on all bits in every z bits in the bit sequence C to obtain the bit sequence $C^t$; or
the processing unit is specifically configured to separately perform t-bit cyclic shift on (z-f) bits in every z bits in the bit sequence C to obtain the bit sequence $C^t$, wherein t is less than or equal to (z-f).

**19.** An apparatus, wherein the apparatus comprises:

a check unit, configured to add redundancy check bits to a bit sequence A corresponding to first information to obtain a bit sequence C;
an encoding unit, configured to perform low-density parity-check LDPC encoding on the bit sequence C to obtain a bit sequence D; and
a processing unit, configured to perform cyclic shift on the bit sequence D based on a shift t and a lifting factor z to obtain a bit sequence $D^t$, wherein t is an integer greater than or equal to 0, and the shift t is obtained based on second information.

**20.** The apparatus according to claim 19, wherein the processing unit is specifically configured to separately perform t-bit cyclic shift on every z bits in the bit sequence D to obtain the bit sequence $D^t$.

**21.** The apparatus according to claim 20, wherein the processing unit is specifically configured to separately perform t-bit cyclic shift on all bits in every z bits in the bit sequence D to obtain the bit sequence $D^t$; or
the processing unit is specifically configured to separately perform t-bit cyclic shift on (z-f) bits in every z bits in the bit sequence D to obtain the bit sequence $D^t$, wherein t is less than or equal to (z-f).

**22.** An apparatus, wherein the apparatus comprises:

a processing unit, configured to perform reverse cyclic shift on a first soft value sequence based on a shift t and a lifting factor z to obtain a soft value sequence corresponding to a bit sequence D, wherein t is an integer greater than or equal to 0;
a decoding unit, configured to perform low-density parity-check LDPC decoding on the soft value sequence corresponding to the bit sequence D to obtain a bit sequence C; and
a check unit, configured to perform redundancy check on the bit sequence C, wherein
the processing unit is further configured to obtain second information based on the shift t if a check result of the check unit is correct.

**23.** An apparatus, wherein the apparatus comprises:

a decoding unit, configured to perform low-density parity-check LDPC decoding based on a first soft value sequence to obtain a bit sequence $C^t$;
a processing unit, configured to perform reverse cyclic shift on the bit sequence $C^t$ based on a shift t and a lifting factor z to obtain a bit sequence C, wherein t is an integer greater than or equal to 0; and
a check unit, configured to perform redundancy check on the bit sequence C, wherein
the processing unit is further configured to obtain second information based on the shift t if a check result of the check unit is correct.

**24.** A communications device, wherein the communications device comprises a processor and a memory, the memory stores an instruction, and the processor is coupled to the memory and is configured to invoke the instruction in the memory to perform the method according to any one of claims 1 to 15.

**25.** A communications apparatus, configured to perform the method according to any one of claims 1 to 15.

**26.** A terminal, comprising the apparatus according to claim 22 or 23 and a transceiver.

**27.** A base station, comprising the apparatus according to any one of claims 16 to 21 and a transceiver.

**28.** A communications system, comprising the terminal according to claim 26 and the base station according to claim 27.

**29.** A computer-readable storage medium, comprising instructions, wherein when the instructions runs on a computer, the instructions makes the computer to perform the method according to any one of claims 1 to 15.

**30.** A computer program product, wherein when the computer program product runs on a computer, the computer program product makes the computer to perform the method according to any one of claims 1 to 15.

FIG. 1

20a

FIG. 2a

FIG. 2b

$$-1 \rightarrow \begin{bmatrix} 0 & 0 & 0 & 0 \\ 0 & 0 & 0 & 0 \\ 0 & 0 & 0 & 0 \\ 0 & 0 & 0 & 0 \end{bmatrix}, 0 \rightarrow \begin{bmatrix} 1 & 0 & 0 & 0 \\ 0 & 1 & 0 & 0 \\ 0 & 0 & 1 & 0 \\ 0 & 0 & 0 & 1 \end{bmatrix}, 1 \rightarrow \begin{bmatrix} 0 & 1 & 0 & 0 \\ 0 & 0 & 1 & 0 \\ 0 & 0 & 0 & 1 \\ 1 & 0 & 0 & 0 \end{bmatrix}, 2 \rightarrow \begin{bmatrix} 0 & 0 & 1 & 0 \\ 0 & 0 & 0 & 1 \\ 1 & 0 & 0 & 0 \\ 0 & 1 & 0 & 0 \end{bmatrix}, 3 \rightarrow \begin{bmatrix} 0 & 0 & 0 & 1 \\ 1 & 0 & 0 & 0 \\ 0 & 1 & 0 & 0 \\ 0 & 0 & 1 & 0 \end{bmatrix}$$

21a     21b     21c     21d     21e

FIG. 2c

301

Add redundancy check bits to a bit sequence A corresponding to first information to obtain a bit sequence C

302

Perform cyclic shift on the bit sequence C based on a shift t and a lifting factor z to obtain a bit sequence $C^t$

303

Perform LDPC encoding on the bit sequence $C^t$ to obtain a bit sequence $D^t$

FIG. 3

401

Add redundancy check bits to a bit sequence A corresponding to first information to obtain a bit sequence C

402

Perform LDPC encoding on the bit sequence C to obtain a bit sequence D

403

Perform cyclic shift on the bit sequence D based on a shift t and a lifting factor z to obtain a bit sequence $D^t$

FIG. 4

501

Perform low-density parity-check LDPC decoding based on a first
soft value sequence to obtain a bit sequence $C^t$

502

Perform reverse cyclic shift on the bit sequence $C^t$ based on a shift t
and a lifting factor z to obtain a bit sequence C

503

If redundancy check is performed on the bit sequence C and a check
result is correct, obtain second information based on the shift t

FIG. 5

601

Perform reverse cyclic shift on a first soft value sequence based on a
shift t and a lifting factor z to obtain a soft value sequence
corresponding to a bit sequence D

602

Perform low-density parity-check LDPC decoding on the soft value
sequence corresponding to the bit sequence D to obtain a bit sequence C

603

If redundancy check is performed on the bit sequence C and a check
result is correct, obtain second information based on the shift t

FIG. 6

Information processing apparatus 700

| Check unit 701 | Processing unit 702 | Encoding unit 703 |

FIG. 7

Information processing apparatus 800

| Check unit 801 | Processing unit 802 | Encoding unit 803 |

FIG. 8

Information processing apparatus 900

| Decoding unit 901 | Processing unit 902 | Check unit 903 |

FIG. 9

Information processing apparatus 1000

| Decoding unit 1001 | Processing unit 1002 | Check unit 1003 |

FIG. 10

Communications device 1100

| Shift encoder 1101 | Transceiver 1102 |

FIG. 11

Communications device 1200

| Shift decoder 1201 | Transceiver 1202 |

FIG. 12

## INTERNATIONAL SEARCH REPORT

| International application No. |
| --- |
| PCT/CN2018/082399 |

### A. CLASSIFICATION OF SUBJECT MATTER

H04L 1/22 (2006.01) i

According to International Patent Classification (IPC) or to both national classification and IPC

### B. FIELDS SEARCHED

Minimum documentation searched (classification system followed by classification symbols)

H04L; H04W; H04B

Documentation searched other than minimum documentation to the extent that such documents are included in the fields searched

Electronic data base consulted during the international search (name of data base and, where practicable, search terms used)

CNTXT; CNABS; VEN; USTXT; WOTXT; EPTXT; CNKI; 3GPP: 移位, 位移, 冗余校验, 扩频, 扩展, 循环移位, 天线端口, 系统帧号, LDPC, cyclic shift, CRC, spreading, factor, antenna port?, SFN, system frame number, shift size, shift value

### C. DOCUMENTS CONSIDERED TO BE RELEVANT

| Category* | Citation of document, with indication, where appropriate, of the relevant passages | Relevant to claim No. |
| --- | --- | --- |
| A | CN 102334319 A (NOKIA SIEMENS NETWORKS), 25 January 2012 (25.01.2012), description, paragraphs 5-11 | 1-30 |
| A | CN 103814539 A (PANASONIC CORPORATION), 21 May 2014 (21.05.2014), description, paragraphs 190-237 | 1-30 |
| A | US 2012327875 A1 (LG ELECTRONIC INC.), 27 December 2012 (27.12.2012), description, paragraphs 60-111 | 1-30 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 06 June 2018 | 20 June 2018 |

| Name and mailing address of the ISA State Intellectual Property Office of the P. R. China No. 6, Xitucheng Road, Jimenqiao Haidian District, Beijing 100088, China Facsimile No. (86-10) 62019451 | Authorized officer WANG, Wenxu Telephone No. (86-512) 88996077 |
| --- | --- |

Form PCT/ISA/210 (second sheet) (January 2015)

## INTERNATIONAL SEARCH REPORT
### Information on patent family members

International application No.

PCT/CN2018/082399

| Patent Documents referred in the Report | Publication Date | Patent Family | Publication Date |
|---|---|---|---|
| CN 102334319 A | 25 January 2012 | SG 173441 A1 | 29 September 2011 |
| | | CA 2753646 C | 04 August 2015 |
| | | AU 2009340792 B2 | 29 January 2015 |
| | | JP 5504287 B2 | 28 May 2014 |
| | | CA 2753646 A1 | 02 September 2010 |
| | | EP 2401847 A1 | 04 January 2012 |
| | | CN 102334319 B | 07 September 2016 |
| | | BR PI0924749 A2 | 26 January 2016 |
| | | KR 20180008881 A | 24 January 2018 |
| | | KR 20160045929 A | 27 April 2016 |
| | | MX 2011008926 A | 21 September 2011 |
| | | JP 2012518960 A | 16 August 2012 |
| | | KR 20130143669 A | 31 December 2013 |
| | | US 2011299625 A1 | 08 December 2011 |
| | | RU 2504094 C2 | 10 January 2014 |
| | | AU 2009340792 A1 | 11 August 2011 |
| | | WO 2010097121 A1 | 02 September 2010 |
| | | KR 20110121653 A | 07 November 2011 |
| | | RU 2011138849 A | 10 April 2013 |
| | | US 8989308 B2 | 24 March 2015 |
| | | SG 173441 B | 31 July 2013 |
| | | VN 28389 A | 26 December 2011 |
| | | IN 201107387 P1 | 08 February 2013 |
| CN 103814539 A | 21 May 2014 | TW I584610 B | 21 May 2017 |
| | | EP 2755339 A4 | 15 April 2015 |
| | | JP 2018023135 A | 08 February 2018 |
| | | WO 2013035336 A1 | 14 March 2013 |
| | | US 2015236768 A1 | 20 August 2015 |
| | | US 9054757 B2 | 09 June 2015 |
| | | CN 103814539 B | 12 April 2017 |
| | | JP 6273611 B2 | 07 February 2018 |
| | | EP 2755339 B1 | 27 December 2017 |
| | | US 9425874 B2 | 23 August 2016 |
| | | JP 2015181243 A | 15 October 2015 |
| | | JP 5784740 B2 | 24 September 2015 |
| | | US 2014219389 A1 | 07 August 2014 |
| | | EP 2755339 A1 | 16 July 2014 |
| | | JP WO2013035336 A1 | 23 March 2015 |
| | | US 2016315679 A1 | 27 October 2016 |
| | | TW 201325129 A | 16 June 2013 |
| US 2012327875 A1 | 27 December 2012 | WO 2011093651 A3 | 10 November 2011 |
| | | WO 2011093651 A2 | 04 August 2011 |
| | | EP 2530896 A4 | 17 May 2017 |
| | | US 2016021652 A1 | 21 January 2016 |
| | | KR 20110088430 A | 03 August 2011 |
| | | CN 102783110 B | 02 September 2015 |
| | | EP 2530896 A2 | 05 December 2012 |
| | | CN 102783110 A | 14 November 2012 |
| | | US 9538511 B2 | 03 January 2017 |
| | | CN 105141399 A | 09 December 2015 |

Form PCT/ISA/210 (patent family annex) (January 2015)

## INTERNATIONAL SEARCH REPORT
### Information on patent family members

| International application No. |
| --- |
| PCT/CN2018/082399 |

| Patent Documents referred in the Report | Publication Date | Patent Family | Publication Date |
| --- | --- | --- | --- |
| | | KR 101782647 B1 | 28 September 2017 |
| | | US 9178677 B2 | 03 November 2015 |

Form PCT/ISA/210 (patent family annex) (January 2015)